# EUROPÄISCHE PATENTANMELDUNG

(11) **EP 2 595 207 A1**
(43) Veröffentlichungstag der Anmeldung: **22.05.2013**
(21) Anmeldenummer: 11189337.6
(22) Anmeldetag: 16.11.2011
(51) Int. Cl.: H01L 33/58, H01L 33/54, H01L 33/60

(54) **Leuchtdiode und Leuchtmittel mit wenigstens einer Leuchtdiode als Lichtquelle**

(71) Anmelder: odelo GmbH, 71409 Schwaikheim (DE)
(72) Erfinder: Kunze, Joe, 47441 Moers (DE); Manth, Thomas, 52076 Aachen (DE); Olkay, Cem, 58454 Witten (DE); Catic, Samir, 51065 Köln (DE)
(74) Vertreter: Benninger, Johannes

(57) **Zusammenfassung**

Es werden eine Leuchtdiode (01) und ein Leuchtmittel mit mindestens einer solchen Leuchtdiode (01) als Lichtquelle (12) beschrieben. Die Leuchtdiode (01) umfasst mindestens einen entlang einer Kegelachse (06) kegelförmig Licht abstrahlenden LED-Chip (02) und einen den LED-Chip (02) zumindest teilweise umgebenden Primäroptikkörper (03), welcher jeweils eine eine Umlenkung von in Richtung entlang der Kegelachse (06) von dem LED-Chip (02) abgestrahlten Lichts um 60°bis 90°weg von der Kegelachse (06) in Richtung einer normal zu der Kegelachse (06) verlaufenden Ebene (08) vermittels Totalreflexion besorgende erste, obere Primäroptikkörperpartie (04) sowie eine Umlenkung von in Richtung entlang der Kegelachse (06) von dem LED-Chip (02) abgestrahlten Lichts um 60°bis 90°weg von der Kegelachse (06) in Richtung einer normal zu der Kegelachse (06) verlaufenden Ebene (08) vermittels Brechung beim Übergang vom Material des Primäroptikkörpers (03) zum diesen umgebenden Medium besorgende, zweite, untere Primäroptikkörperpartie (05) umfasst. Die erste Primäroptikkörperpartie (04) und die zweite Primäroptikkörperpartie (05) lenken zumindest einen Hauptteil des von dem LED-Chip (02) abgestrahlten Lichts in beiden Richtungen entlang einer innerhalb der normal zur Kegelachse (06) liegenden Ebene (08) verlaufenden Hauptachse (09), und den verbleibenden Teil des von dem LED-Chip (02) abgestrahlten Lichts in beiden Richtungen entlang einer innerhalb der normal zur Kegelachse (06) liegenden Ebene (08) verlaufenden Nebenachse (10) um. Das Leuchtmittel (11) umfasst zumindest einen Reflektor (13) mit einer ersten Erstreckung (14) und einer kleineren, zweiten Erstreckung (15), in dessen Brennpunkt (16) die mindestens eine Leuchtdiode (01) angeordnet ist. Die Hauptachse (09) der Leuchtdiode (01) ist entlang der ersten Erstreckung (14) des Reflektors (13) und die Nebenachse (10) der Leuchtdiode (01) ist in Richtung der zweiten Erstreckung (15) des Reflektors (13) orientiert.

## Beschreibung

Die Erfindung betrifft eine Leuchtdiode gemäß dem Oberbegriff des Anspruchs 1 und ein Leuchtmittel mit wenigstens einer solchen Leuchtdiode als Lichtquelle gemäß dem Oberbegriff des Anspruchs 2.

Als Lichtquellen von Leuchtmitteln kommen unter anderem wegen ihres hohen Wirkungsgrads bei der Umwandlung elektrischen Stroms in Licht und ihres damit einhergehend geringen Stromverbrauchs vermehrt Leuchtdioden zum Einsatz.

Herausragende Eigenschaften von Leuchtdioden im Vergleich zu anderen, herkömmlichen Lichtquellen von Leuchtmitteln, wie etwa Glüh- oder Gasentladungslampen, sind eine wesentlich längere Lebensdauer und eine wesentlich höhere Lichtausbeute bei gleicher Leistungsaufnahme. Dadurch und unter anderem auch wegen ihrer kompakteren Abmessungen können durch Verwendung von Leuchtdioden als Lichtquellen Leuchtmittel und damit Leuchten verwirklicht werden, die an fast jede nur erdenkliche Anwendung angepasst sein können.

In einem Leuchtmittel können dabei eine oder mehrere, einzeln oder gruppenweise, beispielsweise in einem Strang zu mehreren angeordnete Leuchtdioden als mindestens eine Lichtquelle vorgesehen sein.

Ein mit einer oder mehreren, einzeln oder gruppenweise angeordneten Leuchtdioden als mindestens eine Lichtquelle ausgestattetes Leuchtmittel kann wenigstens einen Leuchtmittelträger mit Leiterbahnen zur elektrischen Kontaktierung der zumindest einen Leuchtdiode, beispielsweise in Form einer oder mehrerer ebener Platinen mit aufgedruckten oder geätzten Leiterbahnen, so genannter Printed Circuit Boards, kurz PCB, oder in Form eines oder mehrerer als Kunststoffspritzteil in Molded Interconnect Devices (MID) Technik hergestellter, spritzgegossener Schaltungsträger mit in das Kunststoffspritzteil integrierten Leiterbahnen und integrierter mechanischer und elektrischer bzw. elektronischer Funktion umfassen. Auf einem oder mehreren solchen spritzgegossenen Schaltungsträgern mit komplexen Formen können eine oder mehrere Leuchtdioden unter gleichzeitiger mechanischer Befestigung und elektrischer Kontaktierung angeordnet sein. Ebene Platinen bzw. PCBs benötigen selbst einer mechanischen Befestigung beispielsweise in einer Leuchte, wohingegen spritzgegossene Schaltungsträger in MID-Technik selbst Funktionen beispielsweise eines Leuchtengehäuses und/oder eines Reflektors übernehmen und ausführen können, um nur einige Beispiele zu nennen.

Eine zur Verwendung als Lichtquelle eines Leuchtmittels vorgesehene, beispielsweise zur Montage auf einem Leuchtmittelträger ausgebildete Leuchtdiode besteht zumindest aus wenigstens einem Lichtemittierende-Diode-Halbleiter-Chip, kurz LED-Chip, sowie aus mindestens einem Kontaktmittel zur elektrischen Kontaktierung des LED-Chips. Üblicherweise verfügt jede Leuchtdiode über einen Bonddraht je LED-Chip, welcher je einen LED-Chip elektrisch kontaktiert. Dieser Bonddraht bildet wenigstens ein Kontaktmittel der Leuchtdiode. Der Bonddraht kann mit einem elektrischen Anschluss verbunden sein, welcher zur elektrischen Kontaktierung der Leuchtdiode mit einer Leiterbahn des Leuchtmittelträgers vorgesehen ist. Der LED-Chip ist darüber hinaus selbst zur elektrischen Kontaktierung mit einer zweiten Leiterbahn des Leuchtmittelträgers vorgesehen, beispielsweise über einen mit dem LED-Chip verbundenen zweiten elektrischen Anschluss. Auch kann der LED-Chip selbst einen elektrischen Anschluss der Leuchtdiode bilden, wie nachfolgend zu den verschiedenen Kontaktierungsmöglichkeiten von Leuchtdioden noch ausgeführt.

Die Leuchtdiode kann darüber hinaus einen den LED-Chip unmittelbar umgebenden Primärreflektor aufweisen. Dieser Primärreflektor kann beispielsweise durch Wandungen einer den LED-Chip umgebenden Ausnehmung und/oder durch einen Napf gebildet sein, in dem der LED-Chip angeordnet ist. Der Napf kann mit dem erwähnten zweiten Anschluss verbunden sein, diesen bilden oder umfassen oder von diesem umfasst werden. Der zweite Anschluss bildet ebenfalls ein Kontaktmittel der Leuchtdiode. Der zweite Anschluss kann jedoch auch durch den LED-Chip selbst gebildet sein, indem der LED-Chip selbst unmittelbar auf einer ersten Leiterbahn des Leuchtmittelträgers platziert wird. In diesem Fall bilden der auf einer ersten Leiterbahn des Leuchtmittelträgers platzierte LED-Chip und der mit einer zweiten Leiterbahn verbundene Bonddraht die Kontaktmittel und gleichzeitig die elektrischen Anschlüsse der Leuchtdiode.

Bekannt sind Leuchtdioden zur Durchsteckmontage (THT; Through Hole

Technology), oberflächenmontierbare (SMD; Surface Mounted Device) Leuchtdioden und Leuchtdioden, bei denen der LED-Chip in Nacktmontagetechnik (COB; Chip On Board) direkt auf den Leuchtmittelträger gebondet wird.

THT-Leuchtdioden sind der gängig bekannte Typ Leuchtdioden. Sie werden auch als bedrahtete Leuchtdioden bezeichnet, da sie aus einer zumindest in einer gewünschten Abstrahlrichtung transparenten Kapselung, z.B. in Form einer Umspritzung oder eines Vergusses bestehen, welche den mit einem ersten Anschluss, beispielsweise dem Kathodenanschluss verbundenen LED-Chip und einen den LED-Chip mit einem zweiten Anschluss, beispielsweise dem Anodenanschluss verbindenden Bonddraht einschließt. Aus der Kapselung ragen nur die auch als Beinchen bezeichneten Drähte des Anoden- und des Kathodenanschlusses als die elektrischen Anschlüsse der THT-Leuchtdiode. Der erste Anschluss kann hierbei mit einem oben erwähnten Napf versehen sein, in dem der LED-Chip angeordnet ist. Der Bonddraht führt vom zweiten Anschluss von außerhalb des Napfs kommend zum LED-Chip.

SMD-Leuchtdioden bestehen aus einem Leadframe mit wenigstens einer Bestückungsfläche für mindestens einen LED-Chip sowie elektrischen Anschlussflächen. Das Leadframe ist von einem Kunststoffkörper mit zumindest einer die wenigstens eine Bestückungsfläche freihaltenden Ausnehmung teilweise umspritzt. Die elektrischen Anschlussflächen des Leadframes sind hierbei als die elektrischen Anschlüsse der SMD-Leuchtdiode zur späteren Oberflächenmontage ebenfalls freigehalten. Der mindestens eine LED-Chip ist am Grund der zumindest einen zur wenigstens einen Bestückungsfläche reichenden Ausnehmung angeordnet und elektrisch kontaktiert. Dabei ist der LED-Chip auf einer mit wenigstens einer ersten elektrischen Anschlussfläche verbundenen ersten Partie des Leadframes angeordnet. Ein Bonddraht verbindet den LED-Chip mit einer zweiten Partie des Leadframes, die wiederum mit wenigstens einer zweiten elektrischen Anschlussfläche verbunden ist. Die an ihrem Grund zur Bestückungsfläche reichende Ausnehmung kann reflektorartig ausgestaltet sein. Dabei bilden die Wandungen der Ausnehmung den oben erwähnten Primärreflektor. Hierbei können die Wandungen reflektierend beschichtet sein.

COB-Leuchtdioden bestehen aus einem direkt auf einem Leuchtmittelträger anzuordnenden, ungehäusten LED-Chip und einem Bonddraht. Die Rückseite des LED-Chips bildet dabei den ersten elektrischen Anschluss der COB-Leuchtdiode. Zur elektrischen Kontaktierung wird der LED-Chip auf seiner Rückseite direkt mit einer ersten Leiterbahn eines Leuchtmittelträgers z.B. durch Löten oder Schweißen elektrisch verbunden. Der den zweiten elektrischen Anschluss der COB-Leuchtdiode bildende Bonddraht wird mit einer zweiten Leiterbahn des Leuchtmittelträgers ebenfalls z.B. durch Löten oder Schweißen elektrisch verbunden.

Der Vollständigkeit halber sei ergänzend erwähnt, dass auch andere Kontaktierungen wie z.B. der so genannte Flip-Chip-Aufbau möglich sind, bei dem die Kontaktmittel des LED-Chips direkt mit einem elektrisch kontaktierten Substrat verbunden sind. In diesen Fällen wird kein Bonddraht verwendet.

Den beschriebenen Leuchtdioden gemein ist eine durch das Abstrahlverhalten des LED-Chips vorgegebene Abstrahlgeometrie.

Um das von einer oder mehreren Leuchtdioden ausgestrahlte Licht beispielsweise zum Erhalt einer gewünschten Lichtverteilung unter Einhaltung einer vorgegebenen Leuchtdichte in eine oder mehrere Richtungen zu konzentrieren, kann ein mit einer oder mehreren, einzeln oder gruppenweise angeordneten Leuchtdioden als mindestens eine Lichtquelle ausgestattetes Leuchtmittel alternativ oder zusätzlich zu wenigstens einem Leuchtmittelträger mit Leiterbahnen zur elektrischen Kontaktierung der zumindest einen Leuchtdiode einen oder mehrere Reflektoren umfassen.

Jeder einzelnen Leuchtdiode oder einer Gruppe von Leuchtdioden kann dabei ein diese beispielsweise umgebender Reflektor zugeordnet sein, welcher das von mindestens einer Leuchtdiode ausgestrahlte Licht in eine gewünschte Richtung reflektiert.

Die mindestens eine Leuchtdiode und der gegebenenfalls mindestens eine diese umgebende Reflektor bilden dabei in eingeschaltetem Zustand des Leuchtmittels eine als Leuchtfeld bezeichnete, ausgeleuchtete Fläche, über welche das von der wenigstens einen Leuchtdiode ausgestrahlte Licht in einer gewünschten Lichtverteilung zum Erhalt eines homogenen Erscheinungsbilds einhergehend mit einem hochwertigen Qualitätseindruck möglichst gleichmäßig über das Leuchtfeld hinweg verteilt abgestrahlt wird.

So lange das Leuchtfeld in seiner Form der Abstrahlgeometrie einer Leuchtdiode im Sinne einer geometrischen Ähnlichkeitsabbildung ähnlich ist, gestaltet sich die Erfüllung einer homogenen Ausleuchtung des Leuchtfelds vermittels einer zum Erhalt der gewünschten Lichtverteilung unter Einhaltung vorgegebener Leuchtdichten entsprechenden Anzahl von Leuchtdioden und diese umgebenden Reflektoren überschaubar und relativ einfach. Soll ein Leuchtfeld beispielsweise eine Lichtverteilung unter Einhaltung einer vorgegebenen Leuchtdichte aufweisen, die vier mal so hoch ist, wie die unter Verwendung einer Leuchtdiode mit einem entsprechend ausgedehnten Reflektor, können bei einem der Abstrahlgeometrie einer Leuchtdiode ähnlichen Leuchtfeld entweder vier Leuchtdioden gemeinsam in einem entsprechenden Reflektor angeordnet werden, oder 2x2 gleichartige Leuchtdioden mit jeweils zugehörigen Reflektoren vorgesehen werden, die jeweils ein Viertel des Leuchtfelds einnehmen.

Schwierig hingegen verhält es sich bei Leuchtfeldern, deren Form von der Abstrahlgeometrie einer Leuchtdiode abweicht. Eine solche abweichende Form kann beispielsweise durch eine beengte Einbausituation einhergehend mit einer Forderung nach einem bestimmten Flächenmaß für das Leuchtfeld auftreten.

Da die Abstrahlgeometrie von Leuchtdioden entweder radialsymmetrisch oder elliptisch ist, ist für die Verwirklichung von in nur einer Erstreckung ausgedehnte Leuchtfelder, wie sie aufgrund der Einbausituation beispielsweise bei Kraftfahrzeugleuchten in so genannten hochgesetzten Bremsleuchten (HBL) vorkommen, vermittels Leuchtmitteln mit Leuchtdioden und diese umgebenden Reflektoren, eine hohe Anzahl an Reflektoren und Leuchtdioden notwendig. Dabei ist es darüber hinaus zum Erhalt eines hohen Qualitätseindrucks notwendig, jeden Reflektor durch die entsprechende Leuchtdiode voll auszuleuchten, um ein homogenes Erscheinungsbild bei Draufsicht auf das Leuchtfeld zu gewährleisten.

Die Reflektoren müssen dabei zumindest überwiegend in Reihe aneinander angeordnet werden. Varianten von HBL arbeiten zusätzlich mit einer Fresneloptik auf einer gemeinsam mit einem Leuchtengehäuse einen das Leuchtmittel mit den Leuchtdioden und diese umgebenden Reflektoren beherbergenden Leuchteninnenraum abschließenden Lichtscheibe, um das direkt abgestrahlte Licht der Leuchtdioden zusätzlich in die Richtung entsprechend der gewünschten, beispielsweise gesetzlich vorgeschrieben Lichtverteilung zu lenken.

Nachteilig hieran ist die hohe Anzahl an Leuchtdioden sowie diesen zugeordneten Reflektoren, die für ein homogenes Erscheinungsbild notwendig sind. Da von den meisten Automobil-Herstellern gleichzeitig ein Mindestflächenmaß für die Leuchtfelder von HBL besteht, kann die Anzahl der Reflektoren nicht einfach verringert werden, auch wenn die Leuchtdioden an sich lichtstark genug sind, um unter Einhaltung der Lichtverteilung und Leuchtdichte grundsätzlich die Anzahl der Leuchtdioden verringern zu können.

Eine Aufgabe der Erfindung ist es, eine Leuchtdiode zu entwickeln, welche die homogene Ausleuchtung von Leuchtfeldern ermöglicht, deren Form der Abstrahlgeometrie des LED-Chips der Leuchtdiode im geometrischen Sinne nicht ähnlich ist.

Eine Aufgabe der Erfindung ist es außerdem ein Leuchtmittel mit einem homogen ausgeleuchteten, von mindestens einer Leuchtdiode als Lichtquelle und mindestens einem diese umgebenden Reflektor gebildetes Leuchtfeld zu entwickeln, dessen Form der Abstrahlgeometrie eines LED-Chips im geometrischen Sinne nicht ähnlich ist.

Die Aufgabe wird gelöst mit den Merkmalen der unabhängigen Ansprüche.

Die Erfindung sieht demnach zur Lösung der Aufgabe unter gleichzeitiger Behebung der genannten Nachteile des Standes der Technik eine Leuchtdiode mit:
- wenigstens einem entlang einer Kegelachse kegelförmig Licht abstrahlenden LED-Chip,
- vorzugsweise mindestens einer beispielsweise parallel oder normal zur Kegelachse der kegelförmigen Lichtabstrahlung orientierten Montageseite mit elektrischen Anschlüssen zur elektrischen Kontaktierung des LED-Chips,
- vorzugsweise einem unter Freilassung an der gegebenenfalls mindestens einen Montageseite die elektrischen Anschlüsse zumindest teilweise umgebenden, vorzugsweise durch Spritzgießen aus Kunststoff hergestellten Schutzkörper, und
- einem den LED-Chip zumindest teilweise umgebenden, vorzugsweise an diesen angespritzten Primäroptikkörper mit einer ersten, oberen Primäroptikkörperpartie und einer zweiten, unteren Primäroptikkörperpartie zwischen der ersten, oberen Primäroptikkörperpartie und dem LED-Chip,
   welcher Primäroptikkörper sich durch
- eine eine Lichtumlenkung von in Richtung entlang der Kegelachse beispielsweise eines auf der Montageseite aufstehenden Kegels von dem LED-Chip abgestrahlten Lichts um 60°bis 90°weg von der Kegelachse in Richtung einer normal zu der Kegelachse verlaufenden Ebene vermittels in der ersten Primäroptikkörperpartie intern stattfindender Totalreflexion besorgende erste, obere
   Primäroptikkörperpartie und
- eine eine Lichtumlenkung von in Richtung entlang der Kegelachse beispielsweise eines auf der Montageseite aufstehenden Kegels von dem LED-Chip abgestrahlten Lichts um 60°bis 90°weg von der Kegelachse in Richtung einer normal zu der Kegelachse verlaufenden Ebene vermittels in der zweiten Primäroptikkörperpartie stattfindender Brechung beim Übergang vom Material des Primäroptikkörpers zum diesen umgebenden Medium, typischerweise Luft, besorgende, zwischen dem LED-Chip und der ersten Primäroptikkörperpartie angeordnete zweite, untere
   Primäroptikkörperpartie auszeichnet,
- wobei die erste und die zweite Partie zumindest einen Hauptteil des von dem LED-Chip abgestrahlten Lichts in beiden Richtungen entlang einer innerhalb der normal zur Kegelachse liegenden Ebene verlaufenden Hauptachse umlenken,
- und die erste und die zweite Partie den verbleibenden Teil des von dem LED-Chip abgestrahlten Lichts in beiden Richtungen entlang einer innerhalb der normal zur Kegelachse liegenden Ebene normal zu der Hauptachse verlaufenden Nebenachse umlenken.

Das Verhältnis des in Richtung der Hauptachse umgelenkten, von dem LED-Chip abgestrahlten Lichts zu dem in Richtung der Nebenachse umgelenkten, von dem LED-Chip abgestrahlten Lichts entspricht vorzugsweise dem Verhältnis der unterschiedlichen Erstreckungen eines beispielsweise durch einen Reflektor gebildeten Leuchtfelds oder eines beispielsweise durch einen Reflektor gebildeten Teils eines Leuchtfelds in Richtung der Haupt- und Nebenachse, welches Leuchtfeld bzw. welcher Teil des Leuchtfelds mittels der Leuchtdiode ausgeleuchtet wird bzw. werden soll.

Mit anderen Worten weist die Leuchtdiode eine einem auszuleuchtenden Leuchtfeld abgepasste Abstrahlcharakteristik auf.

Die erste Primäroptikkörperpartie kann auf ihrer der zweiten Primäroptikkörperpartie abgewandten Seite zumindest in einem normal zu der Nebenachse wenigstens innerhalb der durch die Kegelachse von dem LED-Chip abgestrahlten Lichts und der Hauptachse aufgespannten Ebene liegenden Querschnitt in Form einer Narrenkappe ausgebildet sein. Solche Formen sind beispielsweise aus Zustandsschaubildern eutektischer Systeme bekannt, wobei die Narrenkappe von der im Eutektischen Punkt nicht differenzierbaren Liquiduslinie nach oben hin begrenzt ist.

Die zweite Primäroptikkörperpartie kann in Form eines sich mit seiner Zylinderachse entlang der Kegelachse erstreckenden Zylinders mit abgeflachten, parallel zur Zylinderachse gegenüberliegenden Seiten ausgeführt sein. Die verbleibenden, die abgeflachten, gegenüberliegenden Seiten miteinander verbindenden parallel zur Zylinderachse angeordneten Oberflächen des Zylinders können in einem Querschnitt normal zur Zylinderachse gesehen beispielsweise konvex oder konkav ausgebildet sein.

In Richtung der Hauptachse können die erste Primäroptikkörperpartie und/oder die zweite Primäroptikkörperpartie konvex gewölbt ausgeführt sein bzw. mit einer normal zur Hauptachse konvex gewölbt verlaufenden ersten Fläche abschließen. Hierdurch kommt es entlang der Wölbung zu einem Austreten des Großteils des von dem LED-Chip entlang der Kegelachse kegelförmig abgestrahlten und auf diese erste Fläche auftreffenden Lichts unter Brechung beim Übergang vom Material des Primäroptikkörpers zum diesen umgebenden Medium, typischerweise Luft.

In Richtung der Nebenachse können die erste Primäroptikkörperpartie und/oder die zweite Primäroptikkörperpartie mit einer normal zur Nebenachse eben verlaufenden zweiten Fläche abschließen. Hierdurch kommt es an der zweiten, ebenen Fläche zum Großteil zu Totalreflexion von von innerhalb des Primäroptikkörpers auf die zweite Fläche auftreffenden, von dem LED-Chip entlang der Kegelachse kegelförmig abgestrahlten Lichts, wodurch dieses auf die erste Fläche umgelenkt wird und dort unter Brechung aus dem Primäroptikkörper austritt.

Denkbar ist, die erste Primäroptikkörperpartie und die zweite Primäroptikkörperpartie beispielsweise in einem zwei- oder mehrstufigen Spritzgussverfahren aus unterschiedlichen Werkstoffen mit unterschiedlichen optischen Eigenschaften, insbesondere unterschiedlichen optischen Brechungsindizes herzustellen.

Grundsätzlich kann auch ein Reflektor, in welchen die Leuchtdiode einstrahlen soll, als Sekundäroptikkörper mit an die Leuchtdiode angespritzt sein, beispielsweise in einem zwei- oder mehrstufigen Spritzgussverfahren. In dem den Reflektor bildenden Sekundäroptikkörper findet zunächst eine Lichtumlenkung in Richtung parallel zur Kegelachse statt, bevor das Licht anschließend aus einer Lichtaustrittsfläche in einer vorgegebenen Lichtverteilung entsprechend einer vorgegebenen Leuchtdichte in einer oder mehreren Vorzugsrichtungen gegebenenfalls unter Brechung beim Übergang vom Material des Sekundäroptikkörpers zum diesen umgebenden Medium, typischerweise Luft, austritt.

Der Primäroptikkörper kann an den LED-Chip angespritzt sein. Die Leuchtdiode ist hierbei in Spritzgusstechnologie ausgeführt.

Die Leuchtdiode kann als SMD-LED ausgeführt sein.

Die Leuchtdiode kann als THT-LED ausgeführt sein.

Als LED-Material kann ein transparenter Thermoplast oder transparentes Silikon zum Einsatz kommen.

Grundsätzlich kann die Leuchtdiode auch als eine COB-Leuchtdiode ausgeführt sein, an welche beispielsweise nach der Nacktchipmontage der Primäroptikkörper sowie gegebenenfalls ein Sekundäroptikkörper angefügt wird.

Ein zweiter Gegenstand der Erfindung betrifft ein Leuchtmittel mit wenigstens einer Leuchtdiode als Lichtquelle und einem Reflektor mit einer die Breite des Reflektors bildenden ersten Erstreckung und einer die Höhe des Reflektors bildenden kleineren, zweiten Erstreckung, welcher sich durch mindestens eine zuvor beschriebene Leuchtdiode auszeichnet, deren Hauptachse entlang der größeren Erstreckung des Reflektors und deren Nebenachse in Richtung der kürzeren Erstreckung des Reflektors orientiert ist.

Wie bereits erwähnt weist die Leuchtdiode eine einem auszuleuchtenden Leuchtfeld abgepasste Abstrahlcharakteristik auf. Dies ist vorzugsweise dadurch sichergestellt, indem das Verhältnis des in Richtung der Hauptachse umgelenkten, von dem LED-Chip abgestrahlten Lichts zu dem in Richtung der Nebenachse umgelenkten, von dem LED-Chip abgestrahlten Lichts dem Verhältnis der unterschiedlichen Erstreckungen des beispielsweise durch einen Reflektor gebildeten Leuchtfelds oder eines beispielsweise durch einen Reflektor gebildeten Teils eines Leuchtfelds in Richtung der Haupt- und Nebenachse entspricht, welches Leuchtfeld bzw. welcher Teil des Leuchtfelds mittels der Leuchtdiode ausgeleuchtet wird.

Das Breiten-Höhen-Verhältnis des Reflektors kann größer 2/1 sein.

Das Leuchtmittel kann einen oder mehrere Leuchtmittelträger mit Leiterbahnen zur elektrischen Kontaktierung der mindestens einen Leuchtdiode umfassen.

Als Leuchtmittelträger können Platinen, PCBs und/oder in MID-Technik hergestellte, spritzgegossene Schaltungsträger zum Einsatz kommen.

Darüber hinaus kann das Leuchtmittel ein oder mehrere beispielsweise auf einem Leuchtmittelträger angeordnete und elektrisch kontaktierte Elektronikbauelemente umfassen.

Zum Betrieb von Leuchtdioden als Lichtquellen für ein Leuchtmittel können eine oder mehrere mehr oder minder komplexe elektronische Steuerschaltungen vorgesehen sein, die beispielsweise auf einem oder mehreren Leuchtmittelträgern des Leuchtmittels angeordnet, dort mechanisch befestigt und elektrisch kontaktiert sein können.

Ein einfaches Beispiel für eine elektronische Steuerschaltung betrifft die Angleichung unterschiedlicher Helligkeiten einzelner Leuchtdioden oder von Leuchtdioden-Strängen innerhalb einer Gruppe gemeinsam betriebener, auf einem oder mehreren Leuchtmittelträgern angeordneter Leuchtdioden. Eine solche elektronische Steuerschaltung besteht aus mindestens einem oder mehreren Vorwiderständen zur Anpassung der Vorwärtsspannung der Leuchtdioden an die Stromversorgung. Beispielsweise ist bekannt, die Leuchtdioden im so genannten Binning nach Vorwärtsspannung und Intensität zu sortieren. Um Unterschiede zwischen mehreren Leuchtdioden-Strängen auszugleichen, die jeweils aus in Reihe geschalteten Leuchtdioden gleicher Vorwärtsspannung und Intensität bestehen, und um eine homogene Helligkeitsverteilung der benachbarten Leuchtdioden-Stränge aus Leuchtdioden mit unterschiedlicher Vorwärtsspannung und Intensität zu erhalten, wird zumindest jeder Leuchtdioden-Strang mit einem anderen Vorwiderstand versehen.

Leuchtdioden bedürfen darüber hinaus beim Einsatz als Lichtquelle insbesondere in Kraftfahrzeugleuchten oft einer separaten Ausfallerkennung. Dies ist bedingt durch die geringe Leistungsaufnahme von Leuchtdioden im Allgemeinen. Beispielsweise ist ein in einem Kraftfahrzeug untergebrachtes Steuergerät nicht in der Lage, eine dem Ausfall einer oder weniger Leuchtdioden entsprechende Änderung der Leistungsentnahme aus dem die Stromversorgung bildenden Bordnetz zu erkennen, da eine hieraus resultierende Bordnetzspannungsänderung unterhalb der im normalen Betrieb eines Kraftfahrzeugs auftretenden Bordnetzspannungssschwankung liegt. Eine beispielsweise in der Kraftfahrzeugleuchte untergebrachte elektronische Schaltungsanordnung zur Ausfallerkennung erfasst den Ausfall einer oder mehrerer Leuchtdioden in der Kraftfahrzeugleuchte z.B. mittels eines oder mehrerer Komparatoren und teilt dies dem Steuergerät mit. Diese elektronische Schaltungsanordnung zur Ausfallerkennung kann durch eine beispielsweise auf dem Leuchtmittelträger aufgebrachte elektronische Steuerschaltung verwirklicht sein.

Darüber hinaus können Leuchtdioden weiterer elektronischer Steuerschaltungen bedürfen. Beispiele hierfür sind elektronische Steuerschaltungen:
- zur Regelung und/oder Steuerung der Helligkeit bzw. Leuchtkraft der Leuchtdioden, beispielsweise durch eine pulsweitenmodulierte Taktung der Stromversorgung für einen außerhalb des für das menschliche Auge wahrnehmbaren Bereichs gepulsten Betrieb,
- zur Kompensation oder Vermeidung elektromagnetischer Störungen, beispielsweise aufgebaut aus Kondensatoren und/oder Ferriten,
- zum Schutz der Leuchtdioden z.B. vor einer Überspannung der Stromversorgung oder vor fehlerhafter Polung, beispielsweise umfassend eine oder mehrere Zenerdioden,

Zusammengefasst muss für fast alle Leuchtdioden-Anwendungen eine mehr oder minder umfangreiche, für die speziellen Leuchtdioden ausgelegte elektronische Steuerschaltung z.B. auf den mindestens einen Leuchtmittelträger aufgebracht werden. Die elektronische Steuerschaltung umfasst im einfachsten Fall einen Vorwiderstand und eine Schutzdiode, kann aber je nach Anwendung auch wesentlich mehr Elektronikbauteile enthalten, wie z.B. Mikrokontroller bzw. Kontroller, Komparatoren, Transistoren, Schutzdioden, elektrische Widerstände z.B. als Vorwiderstand, Kondensatoren, Ferrite, etc.

Somit kann ein Leuchtmittel mit einer oder mehreren Leuchtdioden als Lichtquelle zumindest ein oben genanntes Elektronikbauteil sowie mindestens eine Leuchtdiode umfassen. Demnach kann ein Leuchtmittel mit einer oder mehreren Leuchtdioden als Lichtquellen neben der mindestens einen Leuchtdiode zumindest noch über ein weiteres Elektronikbauelement verfügen.

Es ist ersichtlich, dass die Erfindung durch eine Leuchtdiode mit einem bevorzugt integrierten Primäroptikkörper in Form eines Lichtleitkörpers mit einem durch eine erste Primäroptikkörperpartie gebildeten oberen Teil und einem durch eine zweite Primäroptikkörperpartie gebildeten unteren Teil verwirklicht sein kann. Der obere Teil lenkt das von einem LED-Chip der Leuchtdiode kegelförmig abgestrahlte Licht in Bezug zu einer entlang einer Kegelachse stattfindenden Lichtabstrahlung über interne Totalreflexion an der Grenzfläche um ca. 60°-90° in Richtung normal zur Kegelachse um. Der untere Teil lenkt das Licht vermittels Brechung in die entsprechende Richtung. Von oben betrachtet wird das vom LED-Chip emittierte Licht zusätzlich zu einem Hauptteil in die 0° bzw. 180° Richtung umgelenkt, entsprechend einer in der normal zur Kegelachse liegenden Ebene von 0° nach 180° verlaufenden Hauptachse. In 90° und 270° Richtung entsprechend einer in der normal zur Kegelachse liegenden Ebene von 90° nach 270° ° verlaufenden Nebenachse wird kein oder wenig Licht emittiert. Somit ist eine effiziente Ausleuchtung eines beispielsweise rechteckig geformten, in jedem Fall aber unterschiedliche Erstreckungen in 0° nach 180° und in 90° nach 270° aufweisenden Reflektors möglich.

Die Erfindung wandelt damit die radialsymmetrische bzw. elliptische Abstrahlgeometrie eines LED-Chips in eine der Form eines beispielsweise rechteckigen Reflektors ähnliche Abstrahlgeometrie durch Umlenkung des vom LED-Chip kegelförmig ausgestrahlten Lichts von dessen Haupabstrahlrichtung entlang der Kegelachse zunächst in Richtung normal zur Kegelachse und anschließend im Reflektor nochmals in Richtung parallel zur Kegelachse um.

Hierdurch kann ein beispielsweise rechteckiger Reflektor effizient und gleichmäßig ausgeleuchtet werden.

Vorteile gegenüber dem Stand der Technik ergeben sich unter anderem durch eine Verringerung der benötigten Anzahl von Leuchtdioden und diesen zugeordneten Reflektoren bei schmalen, aber in der Länge ausgedehnten Leuchtfeldern von Leuchtmitteln und Leuchten, wie etwa als HBL ausgebildeten Kraftfahrzeugleuchten, bei gleichzeitig gleichmäßiger Ausleuchtung und damit einhergehend homogenem Erscheinungsbild.

Weitere Vorteile ergeben sich durch die Möglichkeit, eine Leuchtdiode mit einer Abstrahlcharakteristik herzustellen, die einen rechteckigen, länglichen Reflektor ideal homogen ausleuchtet.

Ein solcher rechteckiger Reflektor kann beispielsweise Anwendung in als HBL ausgebildeten Heckleuchten von Kraftfahrzeugen finden.

Zusätzliche Vorteile ergeben sich dadurch, dass mittels der Leuchtdiode Reflektoren mit einem Breite-Höhe-Verhältnis von 3:1 bis hin zu 6:1 homogen ausgeleuchtet werden können. Die Anzahl der Reflektoren, die für die Lichtfunktion beispielsweise von HBL notwendig sind, können deshalb stark verringert werden, ebenso wie die Anzahl der insgesamt benötigten Leuchtdioden. Hierdurch können Einsparungen sowohl bei der Herstellung, beispielsweise durch die Verringerung der insgesamt benötigten Leuchtdioden, als auch während des Betriebs, beispielsweise durch einen verringerten Strombedarf, einhergehend beispielsweise mit einer Verringerung der Belastung eines zur Stromversorgung in einem Kraftfahrzeug vorgesehenen Bordnetzes erzielt werden.

Die Erfindung wird nachfolgend anhand von in den Zeichnungen dargestellter Ausführungsbeispiele näher erläutert. Darin bezeichnen gleiche Bezugszeichen gleiche oder gleich wirkende Elemente. Der Übersicht halber sind nur Bezugszeichen in den einzelnen Zeichnungen dargestellt, die für die Beschreibung der jeweiligen Zeichnung erforderlich sind. Die Größenverhältnisse der einzelnen Elemente zueinander entsprechen dabei nicht immer den realen Größenverhältnissen, da einige Formen vereinfacht und andere Formen zur besseren Veranschaulichung vergrößert im Verhältnis zu anderen Elementen dargestellt sind. Es zeigen in schematischer Darstellung:
- Fig. 1: eine Leuchtdiode mit einem Primäroptikkörper gemäß einem ersten Ausführungsbeispiel in perspektivischer Ansicht.
- Fig. 2: eine Leuchtdiode mit einem Primäroptikkörper gemäß einem zweiten Ausführungsbeispiel in perspektivischer Ansicht.
- Fig. 3: ein Leuchtmittel mit einem Reflektor und einer in dessen Brennpunkt angeordneten Leuchtdiode in perspektivischer Ansicht.

- Fig. 4: Ausführungsbeispiele von Leuchtdioden mit verschieden ausgestalteten Primäroptikkörpern in perspektivischer Ansicht in Fig. 4 a) sowie jeweils in einer Draufsicht in Fig. 4 b) und in Fig. 4 c).
- Fig.5: Ausführungsbeispiele von Leuchtdioden mit verschieden ausgestalteten Primäroptikkörpern in perspektivischer Ansicht in Fig. 5 a), Fig. 5 b) und in Fig. 5 c).
- Fig. 6: ein Ausführungsbeispiel einer Abstrahlcharakteristik einer Leuchtdiode innerhalb einer durch die Kegelachse und die Hauptachse aufgespannten Ebene von der Seite her entlang der Nebenachse gesehen betrachtet.
- Fig. 7: ein Ausführungsbeispiel einer Abstrahlcharakteristik einer Leuchtdiode innerhalb einer durch die Hauptachse und die Nebenachse aufgespannten Ebene von oben her entlang der Kegelachse gesehen betrachtet.
- Fig. 8: ein Ausführungsbeispiel einer Abstrahlcharakteristik einer Leuchtdiode innerhalb einer durch die Hauptachse und die Nebenachse aufgespannten Ebene von oben her entlang der Kegelachse gesehen betrachtet in Fig. 8 a) sowie eine Ausrichtung einer Leuchtdiode mit der Abstrahlcharakteristik aus Fig. 8 a) in einem rechteckigen, die Leuchtdiode umgebenden Reflektor in Fig. 8 b).
- Fig. 9: ein Ausführungsbeispiel einer Abstrahlcharakteristik einer Leuchtdiode innerhalb einer durch die Hauptachse und die Nebenachse aufgespannten Ebene von oben her entlang der Kegelachse gesehen betrachtet in Fig. 9 a) sowie eine Ausrichtung einer Leuchtdiode mit der Abstrahlcharakteristik aus Fig. 9 a) in einem rechteckigen, die Leuchtdiode umgebenden Reflektor in Fig. 9 b).

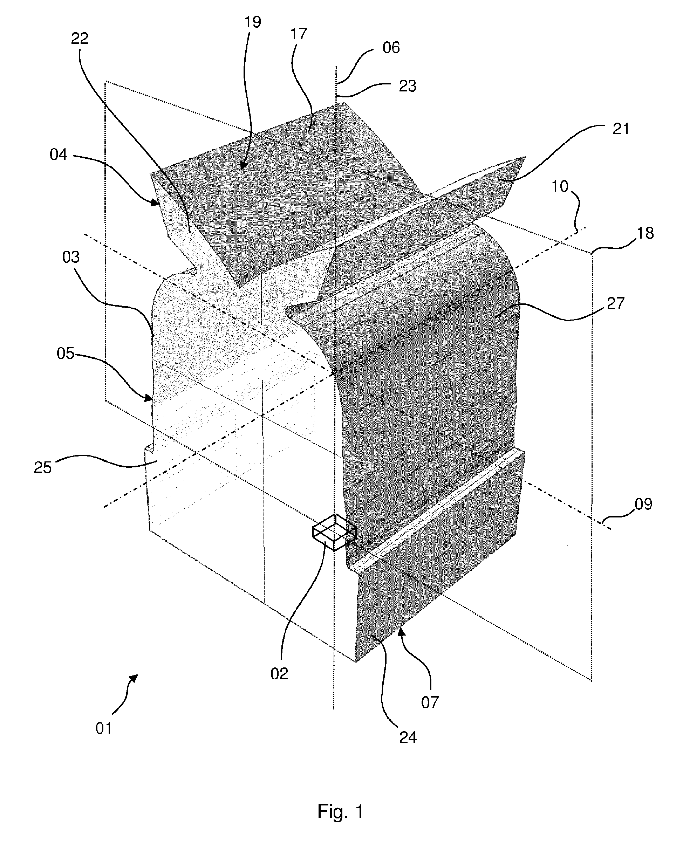

Ein in den Fig. 1 bis Fig. 9 ganz oder in Teilen dargestellte Leuchtdiode 01 umfasst mindestens einen LED-Chip 02 und einen den LED-Chip 02 zumindest teilweise umgebenden, vorzugsweise an diesen angespritzten Primäroptikkörper 03 aus mindestens einem transparenten Werkstoff mit einer ersten, oberen Primäroptikkörperpartie 04 und einer zweiten, unteren Primäroptikkörperpartie 05 zwischen der ersten, oberen Primäroptikkörperpartie 04 und dem LED-Chip 02.

Der LED-Chip 02 strahlt sein Licht kegelförmig entlang einer Kegelachse 06 ab.

Die Leuchtdiode 01 kann mindestens eine beispielsweise parallel oder normal zur Kegelachse 06 der kegelförmigen Lichtabstrahlung orientierte Montageseite 07 mit elektrischen Anschlüssen zur elektrischen Kontaktierung des LED-Chips 02 aufweisen.

Die Leuchtdiode 01 kann einem unter Freilassung an der gegebenenfalls mindestens einen Montageseite 07 die elektrischen Anschlüsse zumindest teilweise umgebenden, vorzugsweise durch Spritzgießen aus Kunststoff hergestellten Schutzkörper umfassen. Der Schutzkörper kann Teil des Primäroptikkörpers 03 sein, von diesem umfasst werden oder diesen umfassen.

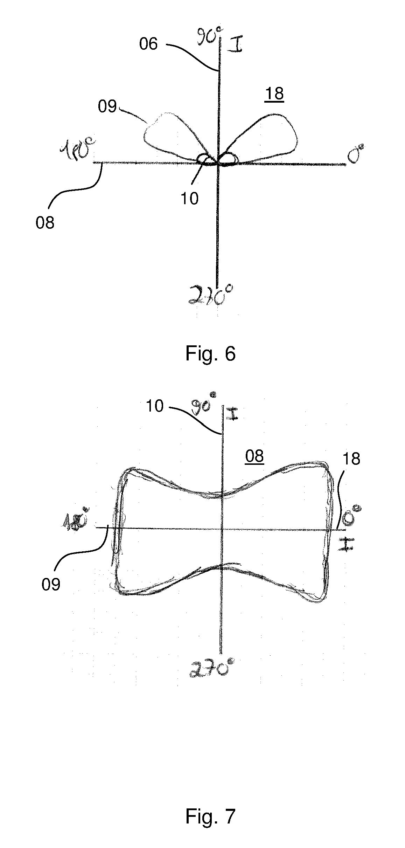

Die erste, obere Primäroptikkörperpartie 04 des Primäroptikkörpers 03 besorgt wie in Fig. 6 dargestellt eine Lichtumlenkung von in Richtung entlang der Kegelachse 06 beispielsweise eines auf der Montageseite 07 aufstehenden Kegels von dem LED-Chip 02 abgestrahlten Lichts um 60° bis 90° weg von der Kegelachse 06 in Richtung einer normal zu der Kegelachse 06 verlaufenden Ebene 08 vermittels in der ersten Primäroptikkörperpartie 04 intern stattfindender Totalreflexion.

Die zwischen dem LED-Chip 02 und der ersten Primäroptikkörperpartie 04 angeordnete zweite, untere Primäroptikkörperpartie 05 des Primäroptikkörpers 03 besorgt wie ebenfalls in Fig. 6 dargestellt eine Lichtumlenkung von in Richtung entlang der Kegelachse 06 beispielsweise eines auf der Montageseite 07 aufstehenden Kegels von dem LED-Chip 02 abgestrahlten Lichts um 60° bis 90° weg von der Kegelachse 06 in Richtung einer normal zu der Kegelachse 06 verlaufenden Ebene 08 vermittels in der zweiten Primäroptikkörperpartie 05 stattfindender Brechung beim Übergang vom Material des Primäroptikkörpers 03 zum diesen umgebenden Medium, typischerweise Luft.

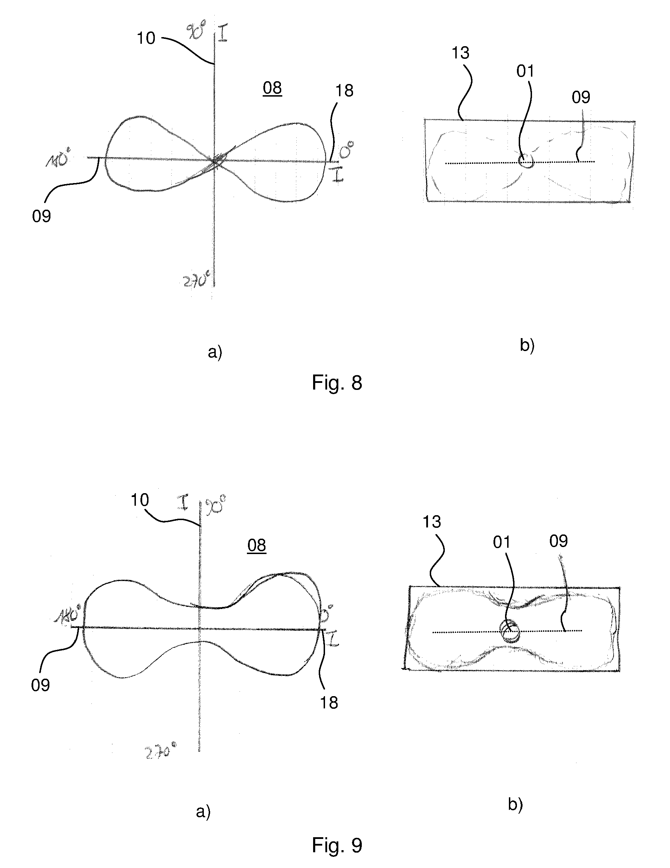

Die erste Primäroptikkörperpartie 04 und die zweite Primäroptikkörperpartie 05 lenken wie in Fig. 7, Fig. 8 a) und Fig. 9 a) dargestellt zumindest einen Hauptteil des von dem LED-Chip 02 abgestrahlten Lichts in beiden Richtungen entlang einer innerhalb der normal zur Kegelachse 06 liegenden Ebene 08 verlaufenden Hauptachse 09 um.

Die erste Primäroptikkörperpartie 04 und die zweite Primäroptikkörperpartie 05 lenken wie in Fig. 7, Fig. 8 a) und Fig. 9 a) dargestellt den verbleibenden Teil des von dem LED-Chip 02 abgestrahlten Lichts in beiden Richtungen entlang einer innerhalb der normal zur Kegelachse 06 liegenden Ebene 08 beispielsweise normal zu der Hauptachse 09 verlaufenden Nebenachse 10 um.

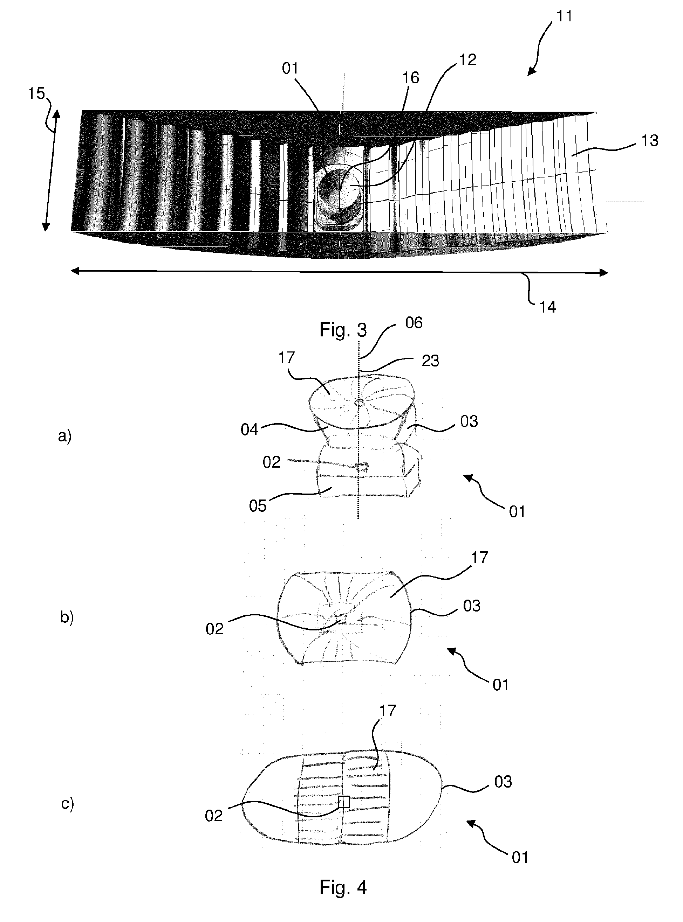

Die Leuchtdiode 01 kann zur Verwendung in einem in Fig. 3 dargestellten Leuchtmittel 11 vorgesehen sein. Ein solches Leuchtmittel 11 umfasst mindestens eine Leuchtdiode 01 als wenigstens eine Lichtquelle 12 und zumindest einen in einer Draufsicht beispielsweise rechteckigen Reflektor 13 mit einer die Breite des Reflektors 13 bildenden ersten Erstreckung 14 und einer die Höhe des Reflektors 13 bildenden kleineren, zweiten Erstreckung 15. Die mindestens eine Leuchtdiode 01 ist im Brennpunkt 16 des Reflektors 13 angeordnet.

Der Reflektor 13 kann ein dem Verhältnis seiner ersten Erstreckung 14 zu seiner zweiten Erstreckung 15 entsprechendes Breiten-Höhen-Verhältnis größer oder gleich 2, vorzugsweise größer oder gleich 3, besonders bevorzugt größer oder gleich 6 aufweisen.

Das Verhältnis des in Richtung der Hauptachse 09 umgelenkten, von dem LED-Chip 02 abgestrahlten Lichts zu dem in Richtung der Nebenachse 10 umgelenkten, von dem LED-Chip 02 abgestrahlten Lichts entspricht vorzugsweise dem Verhältnis der unterschiedlichen Erstreckungen eines durch den Reflektor 13 gebildeten Leuchtfelds oder eines durch den Reflektor 13 gebildeten Teils eines Leuchtfelds in Richtung der Hauptachse 09 und der Nebenachse 10, welches Leuchtfeld bzw. welcher Teil des Leuchtfelds mittels der Leuchtdiode 01 ausgeleuchtet wird bzw. werden soll.

Wichtig ist hervorzuheben, dass der die Leuchtdiode 01 umgebende Reflektor 13 des Leuchtmittels 11, in dem eine Lichtumlenkung des zuvor im Primäroptikkörper 03 weg von der Kegelachse 06 umgelenkten Lichts wieder in Richtung parallel zur Kegelachse 06 stattfindet, Teil der Leuchtdiode 01 sein kann. Beispielsweise kann der Reflektor 13 als Sekundäroptikkörper beispielsweise in einem zwei- oder mehrstufigen Spritzgussverfahren vorzugsweise mit an die Leuchtdiode 01 oder zumindest an deren Primäroptikkörper 03 angespritzt sein, wobei in dem den Reflektor 13 bildenden Sekundäroptikkörper zunächst eine Lichtumlenkung in Richtung parallel zur Kegelachse 06 stattfindet, bevor das Licht anschließend aus einer Lichtaustrittsfläche in einer vorgegebenen Lichtverteilung entsprechend einer vorgegebenen Leuchtdichte in einer oder mehreren Vorzugsrichtungen gegebenenfalls unter Brechung beim Übergang vom Material des Sekundäroptikkörpers zum diesen umgebenden Medium, typischerweise Luft, austritt.

Die Hauptachse 09 der Leuchtdiode 01 ist wie in Fig. 8 b) und Fig. 9 b) dargestellt entlang der größeren, ersten Erstreckung 14 des Reflektors 13 orientiert.

Die Nebenachse 10 der Leuchtdiode 01 ist dabei wie in Fig. 8 b) und Fig. 9 b) dargestellt in Richtung der kleineren, zweiten Erstreckung 15 des Reflektors 13 orientiert.

Die Abstrahlcharakteristik der Leuchtdiode 01 ist dabei dem beispielsweise durch einen oder mehrere Reflektoren 13 mit einer oder mehreren in seinem bzw. ihren Brennpunkten 16 angeordneten Leuchtdioden 01 als Lichtquelle gebildeten, auszuleuchtenden Leuchtfeld des Leuchtmittels 11 angepasst.

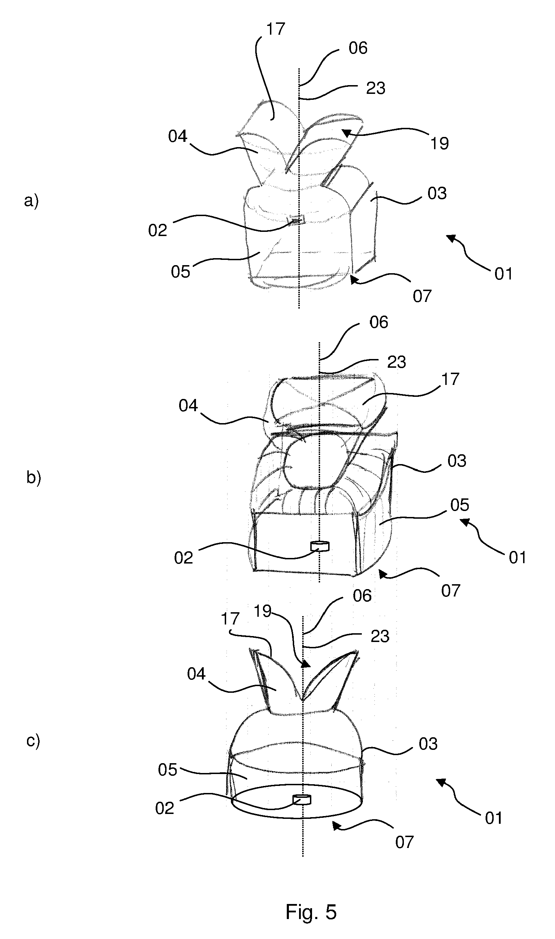

Die erste Primäroptikkörperpartie 04 des Primäroptikkörpers 03 kann auf ihrer der zweiten Primäroptikkörperpartie 05 abgewandten Seite 17 wie in Fig. 1, Fig. 2, Fig. 45 a) und Fig. 5 c) dargestellt, zumindest in einem normal zu der Nebenachse 10 beispielsweise innerhalb einer in Fig. 1, Fig. 2, Fig. 6, Fig. 7, Fig. 8 a) und Fig. 9 a) dargestellten, durch die Kegelachse 06 des kegelförmig von dem LED-Chip 02 abgestrahlten Lichts und der Hauptachse 09 aufgespannten Ebene 18 liegenden Querschnitt gesehen in Form einer Narrenkappe 19 ausgebildet sein. Eine solche Geometrie bzw. solche Formen sind beispielsweise aus Zustandsschaubildern eutektischer Systeme bekannt, wobei die Narrenkappe 19 von der im Eutektischen Punkt nicht differenzierbaren Liquiduslinie nach oben hin begrenzt ist.

Wichtig ist an dieser Stelle hervorzuheben, dass die erste Primäroptikkörperpartie 04 des Primäroptikkörpers 03 auf ihrer der zweiten Primäroptikkörperpartie 05 abgewandten Seite 17 auch eine von einer Narrenkappe 19 abweichende Form aufweisen kann, wie beispielsweise in Fig. 4 a), Fig. 4 b), Fig. 4 c) und Fig. Fig. 5 b) dargestellt.

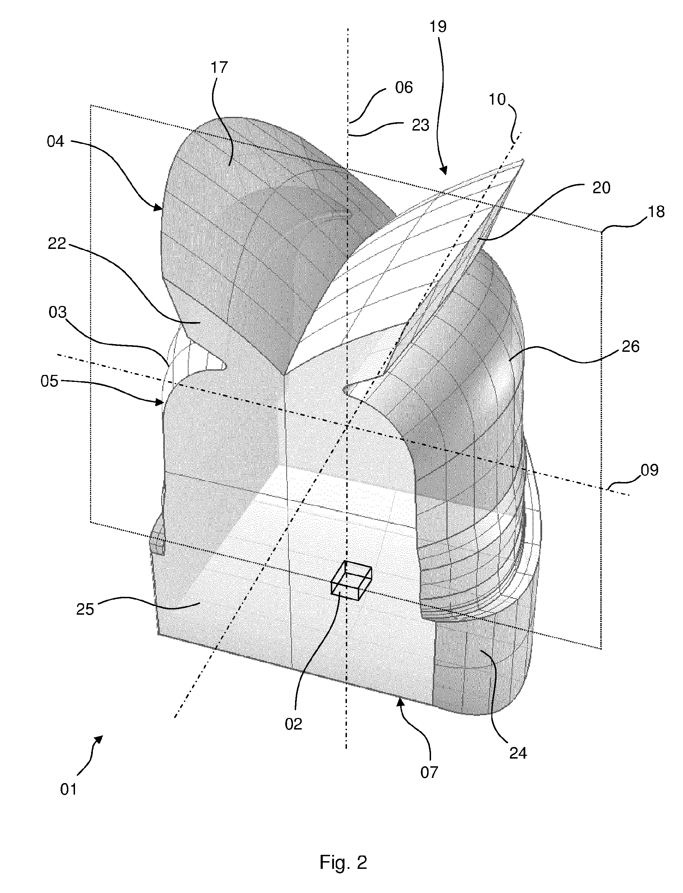

Die erste Primäroptikkörperpartie 04 des Primäroptikkörpers 03 kann wie in Fig. 2 dargestellt in einem normal zur Kegelachse 06 liegenden Querschnitt betrachtet zumindest in Richtung der Hauptachse 09 mit einer konvex gewölbten Fläche 20 abschließen bzw. konvex gewölbt ausgeführt sein.

Auch ein Abschluss der ersten Primäroptikkörperpartie 04 mit einer ebenen Fläche 21 in dieser Richtung ist möglich, wie in Fig. 1 dargestellt.

Die erste Primäroptikkörperpartie 04 des Primäroptikkörpers 03 kann wie in Fig. 1 und in Fig. 2 dargestellt in einem normal zur Kegelachse 06 liegenden Querschnitt betrachtet zumindest in Richtung der Nebenachse 10 mit einer ebenen Fläche 22 abschließen bzw. eben ausgeführt sein.

Die zweite Primäroptikkörperpartie 05 des Primäroptikkörpers 03 kann in Form eines sich mit seiner Zylinderachse 23 entlang der Kegelachse 06 erstreckenden Zylinders 24 mit abgeflachten, parallel zur Zylinderachse 23 gegenüberliegenden Seiten 25 ausgeführt sein, wie in Fig. 1 und Fig. 2 dargestellt.

Die verbleibenden, die abgeflachten, gegenüberliegenden Seiten 25 des Zylinders 24 miteinander verbindenden, sich entlang der Zylinderachse 23 erstreckenden Oberflächen 26 des Zylinders 24 können wie in Fig. 2 dargestellt in einem normal zur Zylinderachse 23 und damit auch normal zur Kegelachse 06 liegenden Querschnitt gesehen konvex und/oder konkav ausgebildet sein.

Auch können die verbleibenden, die abgeflachten, gegenüberliegenden Seiten 25 des Zylinders 24 miteinander verbindenden, sich entlang der Zylinderachse 23 erstreckenden Oberflächen 27 des Zylinders 24 wie in Fig. 1 dargestellt in einem normal zur Zylinderachse 23 und damit auch normal zur Kegelachse 06 liegenden Querschnitt gesehen eben, d.h. lokal im rechten Winkel zur Hauptachse 09 verlaufend ausgebildet sein.

Die zweite Primäroptikkörperpartie 05 des Primäroptikkörpers 03 schließt in einem normal zur Kegelachse 06 liegenden Querschnitt betrachtet zumindest in Richtung der Nebenachse 10 vorzugsweise wie in Fig. 1 und Fig. 2 dargestellt mit abgeflachten Seiten 25 ab. Zusätzlich kann ein Abschluss auch in Richtung der Hauptachse 09 mit rechtwinklig zu dieser verlaufenden Oberflächen 27 vorgesehen sein, wie in Fig. 1 dargestellt.

Alternativ oder zusätzlich schließt die zweite Primäroptikkörperpartie 05 des Primäroptikkörpers 03 in einem normal zur Kegelachse 06 liegenden Querschnitt betrachtet zumindest in Richtung der Hauptachse 09 mit verbleibenden, die gegebenenfalls abgeflachten, gegenüberliegenden Seiten 25 miteinander verbindenden, sich entlang der Zylinderachse 23 bzw. Kegelachse 06 erstreckenden und in einem normal zur Zylinderachse 23 liegenden Querschnitt konkav oder konvex ausgebildeten Oberflächen 26 des Zylinders 24 ab, wie in Fig. 2 dargestellt.

Dabei sind die abgeflachten Seiten 25 der zweite Primäroptikkörperpartie 05 des Primäroptikkörpers normal zur Nebenachse 10 orientiert bzw. die verbleibenden, die abgeflachten, gegenüberliegenden Seiten 25 miteinander verbindenden parallel zur Zylinderachse 23 angeordneten und in einem normal zur Zylinderachse 23 liegenden Querschnitt gesehen ebenen Oberflächen 27 (Fig. 1) bzw. konkav oder konvex ausgebildeten Oberflächen 26 (Fig. 2) des Zylinders 24 mit ihrer lokalen Flächennormalen im geometrischen Schwerpunkt normal zur Hauptachse 09 orientiert.

Die Leuchtdiode 01 kann als Lichtquelle 12 zur Montage auf einem Leuchtmittelträger eines Leuchtmittels 11 verwendet werden.

Die Erfindung ist insbesondere im Bereich der Herstellung von Leuchtdioden bzw. LEDs als Lichtquellen für Beleuchtungszwecke gewerblich anwendbar.

### Bezugszeichenliste

- 01: Leuchtdiode
- 02: LED-Chip
- 03: Primäroptikkörper
- 04: erste Primäroptikkörperpartie
- 05: zweite Primäroptikkörperpartie
- 06: Kegelachse
- 07: Montageseite
- 08: Ebene
- 09: Hauptachse
- 10: Nebenachse
- 11: Leuchtmittel
- 12: Lichtquelle
- 13: Reflektor
- 14: erste Erstreckung
- 15: zweite Erstreckung
- 16: Brennpunkt
- 17: Seite
- 18: Ebene
- 19: Narrenkappe
- 20: Fläche
- 21: Fläche
- 22: Fläche
- 23: Zylinderachse
- 24: Zylinder
- 25: Seite
- 26: Oberfläche
- 27: Oberfläche

## Patentansprüche

1. Leuchtdiode (01) mit:
― wenigstens einem entlang einer Kegelachse (06) kegelförmig Licht abstrahlenden LED-Chip (02), und
― einem den LED-Chip (02) zumindest teilweise umgebenden
Primäroptikkörper (03),
welcher jeweils eine
― eine Umlenkung von in Richtung entlang der Kegelachse (06) von dem LED-Chip (02) abgestrahlten Lichts um 60° bis 90° weg von der Kegelachse (06) in Richtung einer normal zu der Kegelachse (06) verlaufenden Ebene (08) vermittels Totalreflexion besorgende erste, obere Primäroptikkörperpartie (04) und
― eine Umlenkung von in Richtung entlang der Kegelachse (06) von dem LED-Chip (02) abgestrahlten Lichts um 60° bis 90° weg von der Kegelachse (06) in Richtung einer normal zu der Kegelachse (06) verlaufenden Ebene (08) vermittels Brechung beim Übergang vom Material des Primäroptikkörpers (03) zum diesen umgebenden Medium besorgende, zweite, untere Primäroptikkörperpartie (05) umfasst, wobei:
― die erste Primäroptikkörperpartie (04) und die zweite Primäroptikkörperpartie (05) zumindest einen Hauptteil des von dem LED-Chip (02) abgestrahlten Lichts in beiden Richtungen entlang einer innerhalb der normal zur Kegelachse (06) liegenden Ebene (08) verlaufenden Hauptachse (09), und
― die erste Primäroptikkörperpartie (04) und die zweite Primäroptikkörperpartie (05) den verbleibenden Teil des von dem LED-Chip (02) abgestrahlten Lichts in beiden Richtungen entlang einer innerhalb der normal zur Kegelachse (06) liegenden Ebene (08) verlaufenden Nebenachse (10)
umlenken.

2. Leuchtmittel (11) mit mindestens einer Leuchtdiode (01) als wenigstens eine Lichtquelle (12) und zumindest einem Reflektor (13) mit einer ersten Erstreckung (14) und einer kleineren, zweiten Erstreckung (15), in dessen Brennpunkt (16) mindestens eine Leuchtdiode (01) angeordnet ist,
**gekennzeichnet durch**
eine Leuchtdiode (01) nach Anspruch 1, deren Hauptachse (09) entlang der ersten Erstreckung (14) des Reflektors (13) und deren Nebenachse (10) in Richtung der zweiten Erstreckung (15) des Reflektors (13) orientiert ist.

3. Leuchtdiode oder Leuchtmittel nach Anspruch 1 oder 2,
**dadurch gekennzeichnet,**
**dass** die erste Primäroptikkörperpartie (04) auf ihrer der zweiten Primäroptikkörperpartie (05) abgewandten Seite (17) zumindest in einem normal zu der Nebenachse (10) liegenden Querschnitt in Form einer Narrenkappe (19) ausgebildet ist.

4. Leuchtdiode oder Leuchtmittel nach Anspruch 1, 2 oder 3,
**dadurch gekennzeichnet,**
**dass** die erste Primäroptikkörperpartie (04) in einem normal zur Kegelachse (06) liegenden Querschnitt betrachtet zumindest in Richtung der Hauptachse (09) mit einer konvex gewölbten Fläche (20) abschließt.

5. Leuchtdiode oder Leuchtmittel nach einem der Ansprüche 1 bis 4,
**dadurch gekennzeichnet,**
**dass** die erste Primäroptikkörperpartie (04) in einem normal zur Kegelachse (06) liegenden Querschnitt betrachtet zumindest in Richtung der Nebenachse (10) mit einer ebenen Fläche (22) abschließt.

6. Leuchtdiode oder Leuchtmittel nach einem der Ansprüche 1 bis 5,
**dadurch gekennzeichnet,**
**dass** die zweite Primäroptikkörperpartie (05) in Form eines sich mit seiner Zylinderachse (23) entlang der Kegelachse (06) erstreckenden Zylinders (24) mit abgeflachten, parallel zur Zylinderachse (23) gegenüberliegenden Seiten (25) ausgeführt ist.

7. Leuchtdiode oder Leuchtmittel nach Anspruch 6,
**dadurch gekennzeichnet,**
**dass** die verbleibenden, die abgeflachten, gegenüberliegenden Seiten (25) miteinander verbindenden, entlang der Zylinderachse (23) verlaufenden Oberflächen (26, 27) des Zylinders (24) in einem normal zur Zylinderachse (23) liegenden Querschnitt konvex oder konkav oder eben ausgebildet sind.

8. Leuchtdiode oder Leuchtmittel nach Anspruch 6 oder 7,
**dadurch gekennzeichnet,**
**dass** die zweite Primäroptikkörperpartie (05) in einem normal zur Kegelachse (06) liegenden Querschnitt betrachtet zumindest in Richtung der Nebenachse (10) mit abgeflachten Seiten (25) abschließt und/oder zumindest in Richtung der Hauptachse (09) mit die abgeflachten, gegenüberliegenden Seiten (25) miteinander verbindenden, entlang der Zylinderachse (23) verlaufenden und in einem normal zur Zylinderachse (23) liegenden Querschnitt konkav oder konvex oder eben ausgebildeten Oberflächen (26, 27) des Zylinders (24) abschließt.

9. Leuchtdiode oder Leuchtmittel nach einem der vorhergehenden Ansprüche,
**dadurch gekennzeichnet,**
**dass** die erste Primäroptikkörperpartie (04) und die zweite Primäroptikkörperpartie (05) in einem zwei- oder mehrstufigen Spritzgussverfahren hergestellt sind.

10. Leuchtdiode oder Leuchtmittel nach einem der vorhergehenden Ansprüche,
**gekennzeichnet durch**
einen die Leuchtdiode (01) umgebenden Reflektor (13), in dem eine Lichtumlenkung in Richtung parallel zur Kegelachse (06) stattfindet.

11. Leuchtdiode oder Leuchtmittel nach Anspruch 10,
**dadurch gekennzeichnet,**
**dass** der Reflektor (13) eine erste Erstreckung (14) und eine kleinere, zweite Erstreckung (15) aufweist, wobei die Hauptachse (09) entlang der ersten Erstreckung (14) des Reflektors (13) und die Nebenachse (10) in Richtung der zweiten Erstreckung (15) des Reflektors orientiert ist.

12. Leuchtdiode oder Leuchtmittel nach Anspruch 10 oder 11,
**dadurch gekennzeichnet,**
**dass** der Reflektor (13) als Sekundäroptikkörper an die Leuchtdiode (01) angespritzt ist, wobei in dem Sekundäroptikkörper zunächst eine Lichtumlenkung in Richtung parallel zur Kegelachse (06) stattfindet, bevor das Licht aus einer Lichtaustrittsfläche in einer vorgegebenen Lichtverteilung austritt.

13. Leuchtdiode oder Leuchtmittel nach Anspruch 10, 11 oder 12,
**dadurch gekennzeichnet,**
**dass** der Reflektor (13) ein Verhältnis seiner ersten Erstreckung (14) zu seiner zweiten Erstreckung (15) größer 2 aufweist.

14. Leuchtdiode oder Leuchtmittel nach einem der vorhergehenden Ansprüche,
**dadurch gekennzeichnet,**
**dass** die Leuchtdiode (01) als SMD-LED ausgeführt ist.

15. Leuchtdiode oder Leuchtmittel nach einem der vorhergehenden Ansprüche,
**dadurch gekennzeichnet,**
**dass** die Leuchtdiode (01) als THT-LED ausgeführt ist.

## Geänderte Patentansprüche

### Geänderte Patentansprüche gemäss Regel 137(2) EPÜ.

**1.** Leuchtdiode (01) mit wenigstens einem entlang einer Kegelachse (06) kegelförmig Licht abstrahlenden LED-Chip (02), und einem den LED-Chip (02) zumindest teilweise umgebenden Primäroptikkörper (03), welcher jeweils eine eine Umlenkung von in Richtung entlang der Kegelachse (06) von dem LED-Chip (02) abgestrahlten Lichts um 60°bis 90°weg von der Kegelachse (06) in Richtung einer normal zu der Kegelachse (06) verlaufenden Ebene (08) vermittels Totalreflexion besorgende erste, obere Primäroptikkörperpartie (04) und eine Umlenkung von in Richtung entlang der Kegelachse (06) von dem LED-Chip (02) abgestrahlten Lichts um 60°bis 90°weg von der Kegelachse (06) in Richtung einer normal zu der Kegelachse (06) verlaufenden Ebene (08) vermittels Brechung beim Übergang vom Material des Primäroptikkörpers (03) zum diesen umgebenden Medium besorgende, zweite, untere Primäroptikkörperpartie (05) umfasst, wobei:
- die erste Primäroptikkörperpartie (04) und die zweite Primäroptikkörperpartie (05) zumindest einen Hauptteil des von dem LED-Chip (02) abgestrahlten Lichts in beiden Richtungen entlang einer innerhalb der normal zur Kegelachse (06) liegenden Ebene (08) verlaufenden Hauptachse (09), und den verbleibenden Teil des von dem LED-Chip (02) abgestrahlten Lichts in beiden Richtungen entlang einer innerhalb der normal zur Kegelachse (06) liegenden Ebene (08) verlaufenden Nebenachse (10) umlenken,
- die erste Primäroptikkörperpartie (04) in einem normal zur Kegelachse (06) liegenden Querschnitt betrachtet zumindest in Richtung der Nebenachse (10) mit einer ebenen Fläche (22) abschließt, und
- die zweite Primäroptikkörperpartie (05) in Form eines sich mit seiner Zylinderachse (23) entlang der Kegelachse (06) erstreckenden Zylinders (24) mit abgeflachten, parallel zur Zylinderachse (23) gegenüberliegenden Seiten (25) ausgeführt ist.

**2.** Leuchtmittel (11) mit mindestens einer Leuchtdiode (01) nach Anspruch 1 als wenigstens eine Lichtquelle (12),
**gekennzeichnet durch**
zumindest einen Reflektor (13) mit einer ersten Erstreckung (14) und einer kleineren, zweiten Erstreckung (15), in dessen Brennpunkt (16) die mindestens eine Leuchtdiode (01) angeordnet ist, deren Hauptachse (09) entlang der ersten Erstreckung (14) des Reflektors (13) und deren Nebenachse (10) in Richtung der zweiten Erstreckung (15) des Reflektors (13) orientiert ist.

**3.** Leuchtdiode oder Leuchtmittel nach Anspruch 1 oder 2,
**dadurch gekennzeichnet,**
**dass** die erste Primäroptikkörperpartie (04) auf ihrer der zweiten Primäroptikkörperpartie (05) abgewandten Seite (17) zumindest in einem normal zu der Nebenachse (10) liegenden Querschnitt in Form einer Narrenkappe (19) ausgebildet ist.

**4.** Leuchtdiode oder Leuchtmittel nach Anspruch 1, 2 oder 3,
**dadurch gekennzeichnet,**
**dass** die erste Primäroptikkörperpartie (04) in einem normal zur Kegelachse (06) liegenden Querschnitt betrachtet zumindest in Richtung der Hauptachse (09) mit einer konvex gewölbten Fläche (20) abschließt.

**5.** Leuchtdiode oder Leuchtmittel nach einem der vorhergehenden Ansprüche, **dadurch gekennzeichnet,**
**dass** die verbleibenden, die abgeflachten, gegenüberliegenden Seiten (25) miteinander verbindenden, entlang der Zylinderachse (23) verlaufenden Oberflächen (26, 27) des Zylinders (24) in einem normal zur Zylinderachse (23) liegenden Querschnitt konvex oder konkav oder eben ausgebildet sind.

**6.** Leuchtdiode oder Leuchtmittel nach einem der vorhergehenden Ansprüche, **dadurch gekennzeichnet,**
**dass** die zweite Primäroptikkörperpartie (05) in einem normal zur Kegelachse (06) liegenden Querschnitt betrachtet zumindest in Richtung der Nebenachse (10) mit abgeflachten Seiten (25) abschließt und/oder zumindest in Richtung der Hauptachse (09) mit die abgeflachten, gegenüberliegenden Seiten (25) miteinander verbindenden, entlang der Zylinderachse (23) verlaufenden und in einem normal zur Zylinderachse (23) liegenden Querschnitt konkav oder konvex oder eben ausgebildeten Oberflächen (26, 27) des Zylinders (24) abschließt.

**7.** Leuchtdiode oder Leuchtmittel nach einem der vorhergehenden Ansprüche, **dadurch gekennzeichnet,**
**dass** die erste Primäroptikkörperpartie (04) und die zweite Primäroptikkörperpartie (05) in einem zwei- oder mehrstufigen Spritzgussverfahren hergestellt sind.

**8.** Leuchtdiode oder Leuchtmittel nach einem der vorhergehenden Ansprüche, **gekennzeichnet durch**
einen die Leuchtdiode (01) umgebenden Reflektor (13), in dem eine Lichtumlenkung in Richtung parallel zur Kegelachse (06) stattfindet.

**9.** Leuchtdiode oder Leuchtmittel nach Anspruch 8,
**dadurch gekennzeichnet,**
**dass** der Reflektor (13) eine erste Erstreckung (14) und eine kleinere, zweite Erstreckung (15) aufweist, wobei die Hauptachse (09) entlang der ersten Erstreckung (14) des Reflektors (13) und die Nebenachse (10) in Richtung der zweiten Erstreckung (15) des Reflektors orientiert ist.

**10.** Leuchtdiode oder Leuchtmittel nach Anspruch 8 oder 9,
**dadurch gekennzeichnet,**
**dass** der Reflektor (13) als Sekundäroptikkörper an die Leuchtdiode (01) angespritzt ist, wobei in dem Sekundäroptikkörper zunächst eine Lichtumlenkung in Richtung parallel zur Kegelachse (06) stattfindet, bevor das Licht aus einer Lichtaustrittsfläche in einer vorgegebenen Lichtverteilung austritt.

**11.** Leuchtdiode oder Leuchtmittel nach Anspruch 8, 9 oder 10,
**dadurch gekennzeichnet,**
**dass** der Reflektor (13) ein Verhältnis seiner ersten Erstreckung (14) zu seiner zweiten Erstreckung (15) größer 2 aufweist.

**12.** Leuchtdiode oder Leuchtmittel nach einem der vorhergehenden Ansprüche, **dadurch gekennzeichnet,**
**dass** die Leuchtdiode (01) als SMD-LED ausgeführt ist.

**13.** Leuchtdiode oder Leuchtmittel nach einem der vorhergehenden Ansprüche, **dadurch gekennzeichnet,**
**dass** die Leuchtdiode (01) als THT-LED ausgeführt ist.
